# EUROPEAN PATENT APPLICATION

(11) **EP 4 283 872 A2**
(43) Date of publication of application: **29.11.2023**
(21) Application number: 23178166.7
(22) Date of filing: 08.06.2023
(51) Int. Cl.: H03K 3/356

(54) **LEVEL SHIFTER CIRCUIT WITH BACK GATE CONTROLLED TRANSISTORS**

(30) Priority: 24.06.2022 DK PA202200610
(71) Applicant: GN Hearing A/S, 2750 Ballerup (DK)
(72) Inventor: Sønnichsen, Christian, København NV (DK)
(74) Representative: GN Store Nord A/S

(57) **Abstract**

The present invention relates to a level shifter circuit comprising a first output voltage supply, a second output voltage supply, the second output voltage supply having a lower voltage than the first output voltage supply, and a latch circuit comprising a first logic gate having at least two first transistors, each of the first transistors being multi-gate transistors having a front gate and a back gate, a first main input terminal coupled to the back gates of the first transistors, a first secondary input terminal coupled to the front gates of the first transistors, and a first output terminal, a second logic gate having at least two second transistors, each of the second transistors being multi-gate transistors having a front gate and a back gate, a second main input terminal coupled to the back gates of the second transistors, a second secondary input terminal coupled to the front gates of the second transistors, and a second output terminal, and a latch output terminal wherein the first secondary input terminal is coupled to the second output terminal, wherein the second secondary input terminal is coupled to the first output terminal, wherein the latch circuit has a first state in which the latch output terminal is coupled to the first output voltage supply, wherein the latch circuit has a second state in which the latch output terminal is coupled to the second output voltage supply , and wherein the latch circuit is configured for being brought into the first state or the second state based on inputs to the first main input terminal and the second main input terminal.

## Description

The present disclosure relates to a level shifter circuit, the present invention further relates to a multi-level shifter circuit.

### BACKGROUND

Modern integrated circuits for miniature electronic devices, such as hearing aids and other hearing devices, often contain multiple voltage domains. Circuits within separate voltage domains often interact with each other but require so-called "level shifters" to do so because of the supply voltage difference. An example could be a low-voltage digital circuit that sends a signal off-chip or controls an H-bridge or DC-DC conversion circuitry. For conversions with small voltage difference between the low- and high-voltage domains (e.g. 1.0 V, 1.8 V), simple traditional topologies with standard transistor can be used.

However, when level-shifting to higher voltage domains (e.g. 2.5 V, 3.3 V, 3.7 V or 4.2 V) special high-voltage devices such as LDMOS and/or complex topologies are required, and this often results in additional signal delay and power dissipation.

Hence, there is a need for improved level shifters which can shift faster and/or have reduced power dissipation, even when performing relatively high voltage shifts.

### SUMMARY

It is an object of the invention to overcome one or more of the above-mentioned shortcomings. In a first aspect of the invention, this is achieved by a level shifter circuit comprising:
a first output voltage supply, a second output voltage supply , the second output voltage supply having a lower voltage than the first output voltage supply, and a latch circuit comprising
a first logic gate having at least two first transistors, each of the first transistors being multi-gate transistors having a front gate and a back gate, a first main input terminal coupled to the back gates of the first transistors, a first secondary input terminal coupled to the front gates of the first transistors, and a first output terminal,
a second logic gate having at least two second transistors, each of the second transistors being multi-gate transistors having a front gate and a back gate, a second main input terminal coupled to the back gates of the second transistors, a second secondary input terminal coupled to the front gates of the second transistors, and a second output terminal, and
a latch output terminal
wherein the first secondary input terminal is coupled to the second output terminal, wherein the second secondary input terminal is coupled to the first output terminal, wherein the latch circuit has a first state in which the latch output terminal is coupled to the first output voltage supply, wherein the latch circuit has a second state in which the latch output terminal is coupled to the second output voltage supply , and wherein the latch circuit is configured for being brought into the first state or the second state based on inputs to the first main input terminal and the second main input terminal.

It is an advantage of the invention that the back gates are used for input signals as this allows for considerably higher shifts in voltage between the input signal and the output signal. This is because multi-gated transistor generally can handle greater voltage differences between its back gate and source and drain than it can between its front gate and source and drain. Therefore, the voltage difference between the input signal and the target voltage can be significantly greater than what could be applied to a front gate without damaging the transistor. This in turn means that the level shifter according to the invention can be made with a relatively simple circuit which reduces shifting times and power dissipation.

Thus, as an example, the proposed level-shifting concept allows level-shifting up to lithium-ion battery voltage levels only by using 1.0 V and 1.8 V transistors configured in a minimally complex cross-coupled configuration, which helps minimizing the implementation area. Due to the latching operation of the first and second logic gates, the rising and falling propagation delays are equal, which allows precise duty cycle control (e.g. for H-bridge PWM applications).

Further, the invention provides sub-nanosecond propagation delays. The output nodes only charge and discharge between the high voltage supply levels. Also, the bulk-capacitance is small compared to the gate-capacitance (roughly one tenth). The small capacitances combined with limited voltage swings, strong latching operation, and fast transition times result in very low dynamic power dissipation and virtually zero static power dissipation.

In another aspect of the invention one or more of the objects are achieved by a multi-level shifter circuit comprising two or more level shifters according to the first aspect of the invention,
wherein the first main input terminals of the two or more level shifters are connected together,
wherein the second main input terminals of the two or more level shifters are connected together, and
wherein the first voltage supply of each level shifter is provided with different voltages and/or, the second voltage supply of each level shifter circuit is provided with different voltages.

This has the advantages of the first aspect while further enabling voltage shifting to multiple voltage domains, and further saves implementation area, as some features, such as wells or terminals may be used for several of the level shifter circuits. This is useful for systems containing more than two voltage domains.

In a third aspect of the invention hearing device configured to be worn at the ear of a user, wherein the hearing device comprises one or more input transducers, an output transducer, a battery, and circuitry with two or more voltage domains, the circuitry comprising a level shifter circuit according to the first aspect of the invention or a multi-level shifter circuit according to the second aspect of the invention.

It is worth noting, that the numerical definition of *low* and *high voltage* depends on context. In this context the terms high and low voltages are used in the context of micro electronic devices and are used relative to each other. Hence, the differences between high voltage and low voltage might be less than 1 V, which can be a lot for a transistor to handle, unlike other fields of electrical engineering's or layman's definitions which could categorize high voltage as starting around 1000-1500V depending on whether AC or DC voltage is used.

### BRIEF DESCRIPTION OF THE DRAWINGS

The above and other features and advantages of the present invention will become readily apparent to those skilled in the art by the following detailed description of exemplary embodiments thereof with reference to the attached drawings, in which:
Fig. 1 shows a schematic diagram of a level shifter circuit of the invention;
Fig. 2 shows a schematic diagram of a latch circuit of the level shifter circuit;
Fig. 3 shows a schematic diagram of an input circuit of the level shifter circuit;
Fig. 4 shows a schematic cross-sectional view of a logic gate of the latch circuit;
Fig. 5 shows a schematic diagram of a level shifter circuit of the invention;
Fig. 6 shows a schematic cross-sectional view of a logic gate of the latch circuit;
Fig. 7a shows a well configuration of a logic gate of the latch circuit;
Fig. 7b shows a well configuration of a logic gate of the latch circuit;
Fig. 7c shows a well configuration of a logic gate of the latch circuit;
Fig. 7d shows a well configuration of a logic gate of the latch circuit;
Fig. 8 shows a schematic diagram of a level shifter circuit of the invention;
Fig. 9 shows a schematic diagram of a level shifter circuit of the invention;
Fig. 10 shows a schematic diagram of a level shifter circuit of the invention;
Fig. 11a shows a schematic diagram of a multi-level shifter circuit of the invention; and
Fig. 11b shows a graph showing the input and outputs of a multi-level shifter circuit of the invention.

### DETAILED DESCRIPTION

Various exemplary embodiments and details are described hereinafter, with reference to the figures when relevant. It should be noted that the figures may or may not be drawn to scale and that elements of similar structures or functions are represented by like reference numerals throughout the figures. It should also be noted that the figures are only intended to facilitate the description of the embodiments. They are not intended as an exhaustive description of the invention or as a limitation on the scope of the invention. In addition, an illustrated embodiment needs not have all the aspects or advantages shown. An aspect or an advantage described in conjunction with a particular embodiment is not necessarily limited to that embodiment and can be practiced in any other embodiments even if not so illustrated, or if not so explicitly described.

The level shifter circuit and multi-level shifter circuit of the invention are provided on a substrate. Throughout this document, the term substrate refers to the wafer, which the level shifter circuit or multi-level shifter circuit of the invention is manufactured on. In general, the substrate is a semi-conductor, such as crystalline Silicon, which is either P- or N-doped.

In general, the first transistors and the second transistors are configured such that the voltage level that can be applied on the back gate before damaging the respective transistors are higher than the voltage level that can be applied on the front gate before damaging the respective transistors.

In general, the multi-gated first and second transistors are field-effect transistors, FET, that each comprise a source and a drain connected by a channel. To control the flow of current in the channel, an electric field is generated either by the front gate and/or the back gate. The front gate is provided on top and/or on the side, depending on the type of the respective multi-gate transistor, of the channel with a gate oxide separating the front gate from the channel.

The back gate on the other hand, may be provided by providing an electrically insulating layer, such as a buried oxide, BOX, layer, between the source, drain, and channel and the substrate or the well below the respective transistor, so that a voltage may be applied to the substrate or the well, whereby the substrate or the well will affect the conductivity of the channel. Thus, one, more, or all of the first transistors may comprise a BOX layer between the substrate or the well and the channel of the respective first transistor, and/or one, more, or all of the second transistors may comprise a BOX layer between the substrate or the well and the channel of the respective second transistor. The BOX layer may be thicker than the gate oxide.

To provide the back gates of the first and second transistors, the first main input terminal and the second main input terminal may be coupled to the substrate, whereby the substrate may act as a back gate. This approach, however, has the drawback that the circuit would be limited to one universal back gate for all first and second transistors as the substrate carries the entire circuit. Thus, individual control of respective first and second transistors will not be possible through this approach.

A better and more versatile approach is to provide the first and second transistors on wells embedded in the substrate or in other wells. Wells are regions of N-doped, N-wells, semiconductor, such as Silicon, or P-doped, P-wells, semiconductor embedded in the material below, e.g. the substrate or a deeper well. A well needs to be of the opposite doping than the material in which it is embedded. Thus, one or more N-wells may be provided in a P-doped substrate and one or more P-wells may be provided in an N-doped substrate. Furthermore, wells may be provided in other, deeper wells. Thus, one or more N-wells may be provided in a deeper P-well and one or more P-wells may be provided in a deeper N-well.

The first logic gate may comprise one or more first primary well(s), and/or the second logic gate may comprise one or more second primary well(s). The first logic gate may comprise one or more first secondary well(s), each of the one or more first secondary well(s) being embedded in a first primary well, and/or the second logic gate may comprise one or more second secondary well, each of the one or more second secondary well(s) being embedded in a second primary well. The one or more first primary well(s) and the one or more second primary well(s) may be provided in the substrate or in a deeper well. As mentioned above, any well must have the opposite doping the material it is embedded in. As an example, if the substrate is P-doped, one or more first primary well(s) and/or one or more second primary well(s) may be provided in the substrate as N-wells. Furthermore, one or more first secondary well(s) and/or one or more second secondary well(s) may be provided in the primary wells as P-wells.

One or more of the at least two first transistors may be provided on a first primary well and/or one or more of the at least two first transistors may be provided on a first secondary well. One or more of the at least two second transistors may be provided on a second primary well and/or one or more of the at least two second transistors may be provided on a second secondary well. Thereby, the back gate of a respective first or second transistor may be provided by the well which the respective transistor is provided on. It should be noted that multiple transistors can be placed on the same well, whereby that well may act as the back gate for all of those transistors.

Other methods of implementing the back gate are possible. Hence, it will be appreciated that the invention can be implemented on the following technologies: Partially Depleted Silicon on Oxide, PD-SOI, field effect transistor, FET, Fully Depleted Silicon on Oxide, FD-SOI, FET, finFET, flexFET, and other types of independent double or multi-gate transistors. FDSOI is advantageous in that it allows smaller area per functionality.

The latch circuit must have at least two, preferably two, states which it can be brought into depending on the provided input. According to the present invention, the latch circuit has a first state in which the latch output terminal is coupled to the first output voltage supply and a second state in which the latch output terminal is coupled to the second output voltage supply, and the latch circuit is configured for being brought into the first state or the second state based on inputs to the first main input terminal and the second main input terminal. This means that an input signal from can be applied to the first and second main input terminals, whereby an output signal corresponding to the input signal is generated. It should be noted, that for some embodiments of the latch circuit, the input signal will need to be inverted before being applied to the second main input terminal.

The latch circuit may comprise a secondary latch output terminal, wherein, in the first state, the secondary latch output terminal is coupled to the second output voltage supply, and wherein, in the second state, the secondary latch output terminal is coupled to the first output voltage supply. Thus, the second latch output terminal is configured for providing an output, which is the inverted output of the first latch output terminal.

The latch circuit may be implemented in multiple ways, but according to the invention, the first main input terminal must be coupled to the back gates of the first transistors and the second main input terminal coupled to the back gates of the second transistors and the first and second logic gates must be cross-coupled by the first secondary input terminal being coupled to the second output terminal and the second secondary input terminal being coupled to the first output terminal. The latch circuit may be implemented by the first logic gate is an inverter circuit and the second logic gate is an inverter circuit. Alternatively, the first logic gate is a NOR gate or a NAND gate and the second logic gate is a NOR gate or a NAND gate.

The at least two first transistors may comprise a first NMOS transistor and a first PMOS transistor, and/or the at least two second transistors may comprise a second NMOS transistor and a second PMOS transistor. The first logic gate and/or the second logic gate may be asymmetric, i.e. have a strong PMOS transistor and weak NMOS transistor or a weak PMOS transistor and strong NMOS transistor. A strong PMOS transistor and weak NMOS transistor improves the efficiency when level-shifting signals from a low-voltage input to a high-voltage output, while a weak PMOS transistor and strong NMOS transistor improves the efficiency when level-shifting a signal from a high-voltage input to a low-voltage out, or even to a negative voltage domain. Similarly, the second logic gate 200 should also be asymmetric.

The first logic gate and the second logic gate may be symmetric. By symmetric it is meant that the first and second logic gates are the same type of circuit, e.g. inverter circuits, and that the configuration of the first primary well and secondary well are the same as the configuration of the second primary well and secondary well and/or that the configuration of the first transistors, i.e. NMOS and/or PMOS transistors, is the same as the configuration of the second transistors.

The level shifter circuit further comprises an input circuit, the input circuit comprising:
a first input voltage supply, and
a second input voltage supply, the second input voltage supply having a lower voltage than the first input voltage supply,
wherein the first input voltage supply and the second input voltage supply are coupled to the first main input terminal and the second main input terminal, optionally one of the first main input terminal and the second main input terminal being coupled to the first input voltage supply and the second input voltage supply through an input inverter.

The level shifter circuit may be floating, i.e. both the first input voltage supply and the second input voltage supply may have a higher voltage than the first output voltage supply. Also, both the first input voltage supply and the second input voltage supply may have a lower voltage than the second output voltage supply.

Multiple of the level shifter circuits of the invention may be integrated into the same system to provide a multi-level shifter circuit comprising two or more level shifter circuits according to any of the previous claims, wherein the first main input terminals of the two or more level shifter circuits are connected, wherein the second main input terminals of the two or more level shifter circuits are connected, and wherein the first output voltage supply of each level shifter is provided with different voltages and/or the second output voltage supply of each level shifter circuit is provided with different voltages. By providing multiple connected level shifter circuits sharing main input terminals the implementation area may be reduced.

The second output voltage supply of a first level shifter circuit of the two or more level shifters may provide the first output voltage supply of a second level shifter circuit of the two or more level shifters. By using an output voltage supply as both the high, first output voltage supply for a first level shifter circuit and the low, second output voltage supply

Two or more level shifters may share a first primary well, and/or two or more level shifters may share a second primary well. Two or more level shifters may share a first secondary well, and/or two or more level shifters may share a second secondary well. By implementing multiple level shifter circuits on the same well, the implementation area and number of terminals may be reduced.

A particularly useful application for the level shifter circuit and multi-level shifter circuit described above is for hearing devices adapted to be worn at the ear of a user, e.g., hearing aids and ear buds. Such devices comprise many miniature component, many of which operate in different voltage domains. The circuitry may comprise a processor configured to compensate for a hearing loss of a user.

In some embodiments, the hearing device may comprise a power source, i.e. a battery. The power source may comprise a battery providing a first voltage. The battery may be a rechargeable battery. The battery may be a replaceable battery. The power source may comprise a power management unit. The power management unit may be configured to convert the first voltage into a second voltage. The power source may comprise a charging coil configured for recharging the power source.

The hearing device may be of the behind-the-ear, BTE, type, in-the-ear, ITE, type, in-the-canal, ITC, type, receiver-in-canal, RIC, type or receiver-in-the-ear, RITE, type, and/or microphone-and-receiver-in-ear, MaRie, type. The hearing aid may be a binaural hearing aid. The hearing device may comprise a first earpiece and a second earpiece, wherein the first earpiece and/or the second earpiece is an earpiece as disclosed herein.

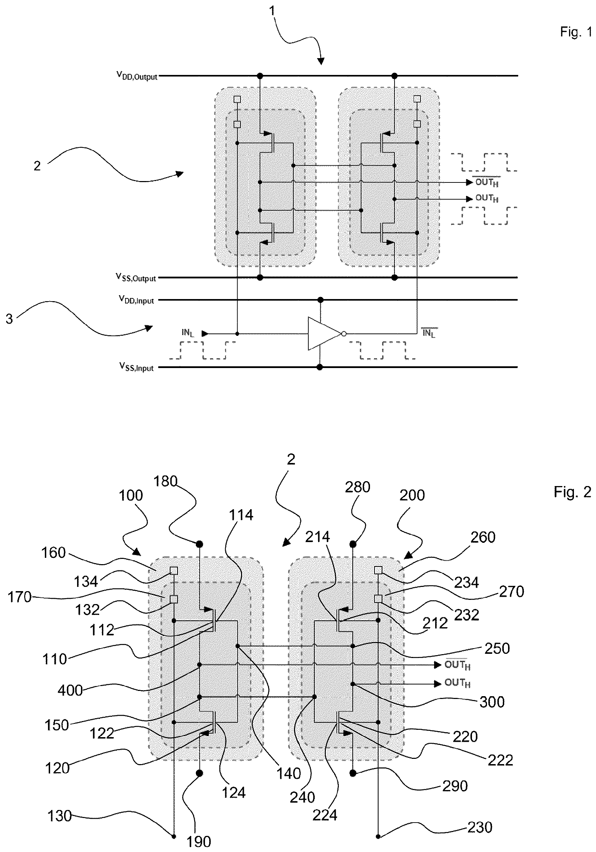

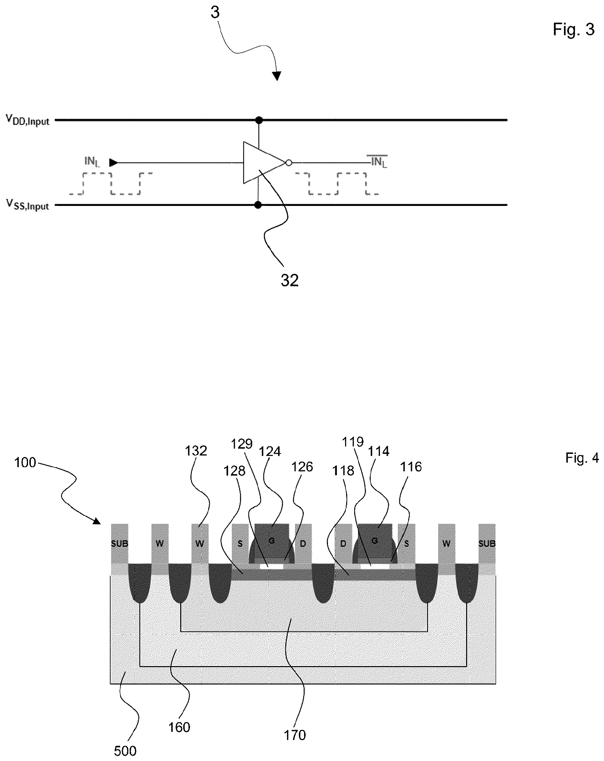

Fig. 1 shows a level shifter circuit 1 according to the invention. The level shifter circuit 1 comprises a latch circuit 2, which is also shown isolated in Fig. 2, and an input circuit 3, which is also shown isolated in Fig. 3. The level shifter circuit further comprises a high, first voltage supply V_{DD,Output} and a low, second voltage supply V_{SS,Output}.

Fig. 2 shows the latch circuit 2 of the level shifter circuit 1 shown in Fig. 1. In the shown embodiment, the latch circuit 2 comprises a first logic gate 100, in the form of an inverter circuit, and a second logic gate 200, also in the form of an inverter. The first logic gate 100 comprises two first transistors 110, 120, each of the first transistors 110, 120 comprising a back gate 112, 122 and a front gate 114, 124. The back gates 112, 122 of the first transistors 110, 120 are connected to a first main input terminal 130 which provides a first way to control of the electrical conductivity of the first transistors 110, 120. The front gates 114, 124 of the first transistors 110, 120 are connected to a first secondary input terminal 140 which provides a second way to control of the electrical conductivity of the first transistors 110, 120.

The two first transistors 110, 120 are coupled in series between a high voltage terminal 180 configured to be connected to the first voltage supply V_{DD,Output} and a low voltage terminal 190 configured to be connected to the second voltage supply V_{SS,Output}. As can be seen from the transistor symbols in Fig. 2, one of the first transistors is a PMOS transistor 110 and one is an NMOS transistor 120, the PMOS transistor 110 being arranged between the high voltage terminal 180 and the NMOS transistor 120 and the NMOS transistor 120 being arranged between the low voltage terminal 190 and the PMOS transistor 110.

The first logic gate comprises a first output terminal 150 arranged between the PMOS transistor 110 and the NMOS transistor 120. Thereby, the first output terminal 150 may be coupled to the first voltage supply V_{DD,Output} by opening the PMOS transistor 110 and closing the NMOS transistor 120, or it may be coupled to the second voltage supply V_{SS,Output} by closing the PMOS transistor 110 and opening the NMOS transistor 120.

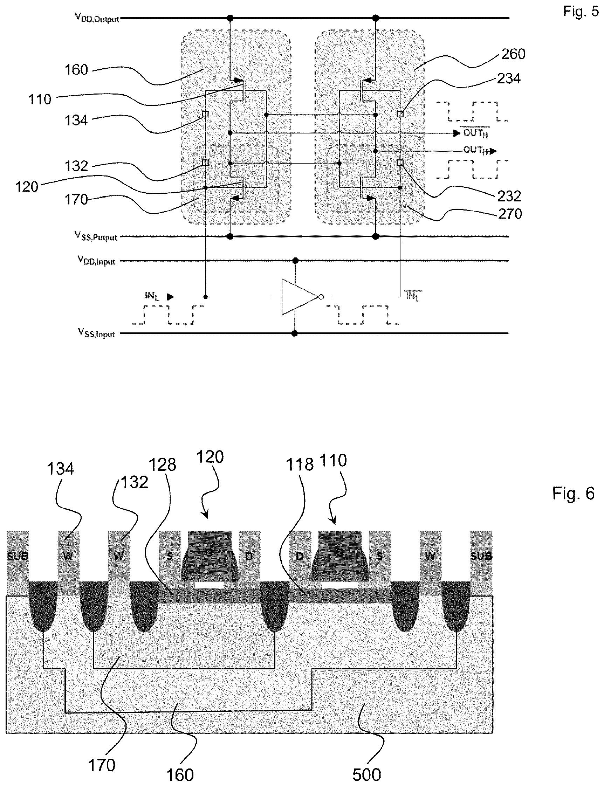

To provide the back gates 112, 122 of the first transistors 110, 120, the first logic gate 100 has been arranged on top of a first secondary well 170, which is embedded in a first primary well 160, which in turn is embedded in the substrate. In the shown embodiment, the substrate is P doped, which means the first primary well 160 is N doped, i.e. an N-well, while the first secondary well 170 is P doped, i.e. a P-well. The shown embodiment is implemented in FDSOI technology, which means that a BOX layer (shown in Fig. 5) is provided between the first transistors 110, 120 and the underlying wells 160, 170, so that the first transistors 110, 120 is isolated from the wells 160. Thereby, a voltage may be applied to the first secondary well 170, which in turn generates an electric field that will affect the conductivity of the first transistors 110, 120 arranged on that well. To apply the voltage to the first secondary well 170, the first main input terminal 130 is coupled to a first secondary well contact 132 connected to the first secondary well 170. It should be noted that in Fig. 2 a line connects the first main input 130 and the first transistors 110, 120. This line is illustrative and illustrates the back gates 112, 122, which, as described above, is actually realized by the underlying first secondary well 170.

The front gates 114, 124 of the first transistors 110, 120 provide additional control of the first transistors 110, 120. The front gates 114, 124 may be implemented as in traditional MOSFET technology, by arranging a gate electrode on top of the respective first transistors 110, 120 with a gate oxide between the gate electrode and the channel, source, and drain of the respective transistor. The front gates 114, 124 are coupled to a first secondary input terminal 140 through which a voltage can be applied to the front gates 114, 124 of the first transistors 110, 120.

The latch circuit 2 further comprises a second logic gate 200. The second logic gate 200 is symmetric to the first logic gate 100 and thus comprise the same features. Thus, the second logic gate 200 comprises two second transistors 210, 220, each of the second transistors 210, 220 comprising a back gate 212, 222 and a front gate 214, 224. The back gates 212, 222 of the second transistors 210, 220 are connected to a second main input terminal 230 which provides a first way to control of the electrical conductivity of the second transistors 210, 220. The front gates 214, 224 of the second transistors 210, 220 are connected to a second secondary input terminal 240 which provides a second way to control of the electrical conductivity of the second transistors 210, 220.

The two second transistors 210, 220 are coupled in series between a high voltage terminal 280 configured to be connected to the first voltage supply V_{DD,Output} and a low voltage terminal 290 configured to be connected to the second voltage supply V_{SS,Output}. As can be seen from the transistor symbols in Fig. 2, one of the first transistors is a PMOS transistor 210 and one is an NMOS transistor 220, the PMOS transistor 210 being arranged between the high voltage terminal 280 and the NMOS transistor 220 and the NMOS transistor 220 being arranged between the low voltage terminal 290 and the PMOS transistor 210.

The second logic gate 200 comprises a second output terminal 250 arranged between the PMOS transistor 210 and the NMOS transistor 220. Thereby, the second output terminal 250 may be coupled to the first voltage supply V_{DD,Output} by opening the PMOS transistor 210 and closing the NMOS transistor 220, or it may be coupled to the second voltage supply V_{SS,Output} by closing the PMOS transistor 210 and opening the NMOS transistor 220.

To provide the back gates 212, 222 of the second transistors 210, 220, the second logic gate 200 has been arranged on top of a second secondary well 270, which is embedded in a second primary well 260, which in turn is embedded in the substrate. In the shown embodiment, the substrate is P-doped, which means the second primary well 260 is N-doped, i.e. an N-well, while the second secondary well 270 is P-doped, i.e. a P-well. The shown embodiment is implemented in FDSOI technology, which means that a BOX layer (shown in Fig. 5) is provided between the second transistors 210, 220 and the underlying wells 260, 270, so that the second transistors 210, 220 are isolated from the second secondary well 270. Thereby, a voltage may be applied to the second secondary well 270, which in turn generates an electric field that will affect the conductivity of the second transistors 210, 220 arranged on that well. To apply the voltage to the second secondary well 270, the second main input terminal 230 is coupled to a second secondary well contact 232 connected to the second secondary well 270. It should be noted that in Fig. 2 a line connects the second main input 230 and the second transistors 210, 220. This line is illustrative and illustrates the back gates 212, 222, which, as described above, is actually realized by the underlying second secondary well 270.

The front gates 214, 224 of the second transistors 210, 220 provide additional control of the second transistors 210, 220. The front gates 214, 224 may be implemented as in traditional MOSFET technology, by arranging a gate electrode on top of the respective second transistors 210, 220 with a gate oxide between the gate electrode and the channel, source, and drain of the respective transistor. The front gates 214, 224 are coupled to a second secondary input terminal 240 through which a voltage can be applied to the front gates 214, 224 of the first transistors 210, 220.

The first and second logic gates 100, 200 are cross-coupled by connecting the first secondary input terminal 140 to the second output terminal 250 and connecting the second secondary input terminal 240 to the first output terminal 150. Thus, the output of the first output terminal 150 will be applied to the front gates 214, 224 of the second transistors 210, 220 and the output of the second output terminal 250 will be applied to the front gates 114, 124 of the first transistors 110, 120.

The first logic gate 100 should be asymmetric, i.e. have a strong PMOS transistor and weak NMOS transistor to efficiently level-shift signals from a low-voltage input to a high-voltage output, or a weak PMOS transistor and strong NMOS transistor to efficiently level-shift a signal from a high-voltage input to a low-voltage out, or even to a negative voltage domain. Similarly, the second logic gate 200 should also be asymmetric.

The input circuit 3, shown in Fig. 3, is configured for providing an input signal to the first main input terminal 130 and an input signal to the second main input terminal 210. To do this, the input circuit comprises a first input voltage supply V_{DD,Input} and a second input supply V_{SS,input}, the first input voltage supply V_{DD,Input} providing a higher voltage than the second input supply V_{SS,input}. In the embodiment shown in Fig. 1, the level shifter circuit 1 is configured for shifting from a low input to a high output, which means that the first input voltage supply V_{DD,Input} and a second input supply V_{SS,input} both provide a lower voltage than the second voltage supply V_{SS,Output}. In embodiments where the level shifter circuit is configured for shifting from a high input to a low output, the first input voltage supply V_{DD,Input} and the second input supply V_{SS,input} will both provide a greater voltage than the first voltage supply V_{DD,Output}.

Although Fig. 3 does not show the input signal IN_{L} being coupled to the first input voltage supply V_{DD,Input} and the second input supply V_{SS,Input}, it should be understood that the input signal IN_{L} will be supplied from these sources. Thus, the input signal IN_{L} will have one of these two voltages, corresponding to the binary values of 0 and 1. Naturally, the input signal may change between the first input voltage supply V_{DD,Input} and the second input supply V_{SS,input} over time. For the level shifter circuit 1 shown in Fig. 1 to work properly, the input signal applied to the second main input terminal 230 must be the inverted signal applied to the first main input terminal 130. Therefore, the input circuit 3 comprises an inverter 32, which takes the input signal IN_{L} as an input and provides an inverted input signal *I̅N̅_̅{̅L̅}̅*. Thus, if the input signal IN_{L} is the first input voltage supply V_{DD,Input} the inverted input signal *I̅N̅_̅{̅L̅}̅* will be the second input supply V_{SS,Input}, and if the input signal IN_{L} is the second input voltage supply V_{SS,Input} the inverted input signal *I̅N̅_̅{̅L̅}̅* will be the first input supply V_{DD,input}.

The operational principle of the level shifter circuit 1 is as follows: when the input signal IN_{L} is low, i.e. the second input voltage supply V_{SS,Input}, the first logic gate 100 will have the second input voltage supply V_{SS,Input}, applied to the back gates 112, 122 of the first transistors 110, 120, while the second logic gate 200, which receives the inverted input signal *I̅N̅_̅{̅L̅}̅*, will have the first input voltage supply V_{DD,Input}, applied to the back gates 212, 222 of the second transistors 210, 220. In this state, the PMOS transistor 110 of the first logic gate 100 will begin to conduct due to the low voltage applied to its back gate 112 and the NMOS transistor 120 of the first logic gate 100 will begin to close due to the low voltage applied to its back gate 122. At the same time, the PMOS transistor 210 of the second logic gate 200 will begin to close due to the high voltage applied to its back gate 212 and the NMOS transistor 220 of the second logic gate 200 will begin to conduct due to the high voltage applied to its back gate 222. This in turn means that the first output terminal 150 will be coupled to the first output voltage supply V_{DD,Output} which will be applied to the front gates 214, 224 of the second logic gate 200, which enforces the closing of PMOS transistor 210 of the second logic gate 200 and the opening of NMOS transistor 220 of the second logic gate 200, and that the second output terminal 250 will be coupled to the second output voltage supply V_{SS,Output} which will be applied to the front gates 114, 124 of the first logic gate 100, which enforces the opening of PMOS transistor 110 of the first logic gate 100 and the closing of NMOS transistor 120 of the first logic gate 100.

If on the other hand the input signal IN_{L} is high, i.e. the first input voltage supply V_{DD,Input}, the first logic gate 100 will have the first input voltage supply V_{DD,Input}, applied to the back gates 112, 122 of the first transistors 110, 120, while the second logic gate 200, which receives the inverted input signal *I̅N̅_̅{̅L̅}̅,* will have the second input voltage supply V_{SS,Input}, applied to the back gates 212, 222 of the second transistors 210, 220. In this state, the PMOS transistor 110 of the first logic gate 100 will begin to close due to the high voltage applied to its back gate 112 and the NMOS transistor 120 of the first logic gate 100 will begin to open due to the high voltage applied to its back gate 122. At the same time, the PMOS transistor 210 of the second logic gate 200 will begin to open due to the low voltage applied to its back gate 212 and the NMOS transistor 220 of the second logic gate 200 will begin to close due to the low voltage applied to its back gate 222. This in turn means that the first output terminal 150 will be coupled to the second output voltage supply V_{SS,Output} which will be applied to the front gates 214, 224 of the second logic gate 200, which enforces the opening of PMOS transistor 210 of the second logic gate 200 and the closing of NMOS transistor 220 of the second logic gate 200, and that the second output terminal 250 will be coupled to the first output voltage supply V_{DD,Output} which will be applied to the front gates 114, 124 of the first logic gate 100, which enforces the closing of PMOS transistor 110 of the first logic gate 100 and the opening of NMOS transistor 120 of the first logic gate 100.

To extract an output signal OUT_{H}, the latch circuit 2 comprises a latch output terminal 300 arranged between the PMOS transistor 210 of the second logic gate 200 and the NMOS transistor 220 of the second logic gate 200. According to the operational principle described above, the latch output terminal 300 will be coupled to the first, high, output voltage supply V_{DD,Output} when the input signal IN_{L} is high, and to the second, low, output voltage supply V_{SS,Output} when the input signal IN_{L} is low. Hence, the output signal OUT_{H} will be equivalent the input signal IN_{L} except that it will be shifted from the input voltages to the output voltages.

The latch circuit 2 further comprises a second latch output terminal 400 which provides an inverted output signal *O̅U̅T̅_̅{̅H̅}̅*. The second latch output terminal 400 is arranged between the PMOS transistor 110 of the first logic gate 100 and the NMOS transistor 120 of the first logic gate 100. According to the operational principle described above, the second latch output terminal 400 will be coupled to the first, high, output voltage supply V_{DD,Output} when the input signal IN_{L} is low, and to the second, low, output voltage supply V_{SS,Output} when the input signal IN_{L} is high. Hence, the inverted output signal *O̅U̅T̅_̅{̅H̅}̅* will be an inverted equivalent of the input signal IN_{L} and it will be shifted from the input voltages to the output voltages.

For designers accustomed to bulk CMOS this invention may sound like a very challenging design case, but for technologies like FDSOI this is possible. Rather small device sizes can be used since PMOS transistors operated in high-voltage domains will be naturally forward biased when the body potential is kept in the low-voltage domain, while the opposite is true for the NMOS transistors which are naturally reverse biased under these conditions.

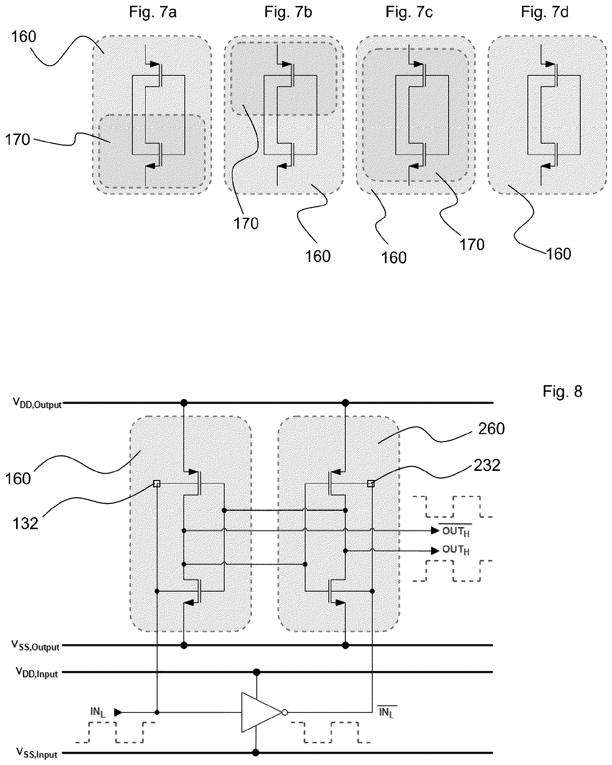

To further the asymmetry of the PMOS-type and NMOS-type transistors, the inverters (logic gates) 100, 200 can be implemented in P-wells as shown in Fig. 2. This causes a threshold voltage shift, so that the PMOS becomes a low-threshold voltage, LVT, device, while the NMOS retains regular threshold voltage, RVT. This is not a requirement, but it further improves the performance of the level-shifter and decreases the implementation area. While certain well configurations may improve performance, the concept is implementable in any P or N well configuration due to the BOX, some of which being shown in Figs. 7a-d.

The embodiment of Figs. 1-3 has been simulated in an analogue circuit simulator, and implemented with a minimum-size thin-oxide (1.0 V) LVT PMOS (W / L = 80 nm / 30 nm) combined with a thick-oxide (1.8 V) RVT NMOS (W/L = 300 nm/4 µm) results in approximately 50-100 picoseconds propagation delay when level-shifting a signal in the range 0 V to 1.8 V to the range 3.5 V to 4.2 V.

Fig. 4 shows a cross-sectional view of the first logic gate 100 shown in Figs. 1 and 2. The first transistors 110, 120 are implemented above a first secondary well 170, which is embedded in a deeper first primary well 160, which in turn is embedded in a substrate 500. To isolate the first transistors 110, 120 from the first secondary well 170, a BOX layer 116, 126 has been provided between each first transistor 110, 120 and the first secondary well 170. Thereby, the first secondary well 170 may act as the back gate for the first transistors 110, 120, as a voltage may be applied to the first secondary well 170 via the first secondary well contact 132. The front gate 114, 124 of each first transistor 110, 120 may be implemented as known from MOSFET technology, by providing a gate electrode on the channel 119, 129 of a transistor, with a gate oxide layer 116, 126 separating the gate electrode and the channel.

Fig. 5 shows an embodiment of the level shifter circuit 1 shown in Fig. 1. The level shifter circuit shown in Fig. 4 differs in that latch circuit 2 comprises a different well configuration. In the shown embodiment, the first logic gate 100 comprises a first primary well 160 embedded in the substrate and a first secondary well 170 embedded in the first primary well 160. The shown level shifter circuit 1 is implemented on a P-doped substrate so the first primary well 160 is an N-well and the first secondary well 170 is a P-well. Similarly to the embodiment shown in Fig. 1, the first logic gate 100 comprises a two first transistors 110, 120, one that is a PMOS transistor 110 and one that is an NMOS transistor 120.

The PMOS transistor 110 is arranged on top of the first primary well 160 while the NMOS transistor 120 is arranged on top of the first secondary well 170. Thus, the first primary well 160 provides the back gate for the PMOS transistor 110 and the first secondary well 170 provides the back gate for the NMOS transistor 120. The first logic gate 100 comprises a first primary well contact 134, which couples the first primary well 160 to the first main input terminal 130, and a first secondary well contact 132, which couples the first secondary well 170 to the first main input terminal 130.

The second logic gate 200 is symmetric to the first logic gate 100. Thus, the second logic gate 200 comprises a second primary well 260 embedded in the substrate and a second secondary well 270 embedded in the second primary well 260. The shown level shifter circuit 1 is implemented on a P-doped substrate so the second primary well 260 is an N-well and the second secondary well 270 is a P-well. Like the first logic gate 100, the second logic gate 200 comprises a two second transistors 210, 220, one that is a PMOS transistor 210 and one that is an NMOS transistor 220.

The PMOS transistor 210 is arranged on top of the second primary well 260 while the NMOS transistor 220 is arranged on top of the second secondary well 270. Thereby, the second primary well 260 provides the back gate for the PMOS transistor 210 and the second secondary well 270 provides the back gate for the NMOS transistor 220. The second logic gate 200 comprises a second primary well contact 234, which couples the second primary well 260 to the second main input terminal 230, and a second secondary well contact 232, which couples the second secondary well 270 to the second main input terminal 230.

In this configuration both the NMOS transistors 120, 220 of the first and second logic gates 100, 200 and the PMOS transistors 110, 210 of the first and second logic gates 100, 200 retains regular threshold voltage, RVT.

Fig. 6 shows a cross-sectional view of the first logic gate 100 of the embodiment shown in Fig. 5. As described above, the first primary well 160 is embedded in the substrate 500, while the first secondary well 170 is embedded in the first primary well 160. The NMOS, first transistor 110 comprises a BOX layer 118 so as to separate the source, channel, and drain of the NMOS transistor 110 from the underlying first primary well 160. Similarly, the PMOS, first transistor 120 also comprises a BOX layer 128 so as to separate the source, channel, and drain of the PMOS transistor 120 from the underlying first secondary well 160.

As mentioned above, the invention may work with multiple well configurations. Figs. 7a-d show four such configurations in a P-doped substrate 500. Fig. 7a, shows the configuration used for the embodiment shown in Figs. 5 and 6, where a P-type secondary well 170 and an N-doped primary well 160 is used. Fig. 7b shows an embodiment where a P-doped secondary well 170 is used as the back gate for the PMOS transistor and an N-doped primary well 160 is used as the back gate for the NMOS transistor, whereby both the PMOS and NMOS transistors becomes a low-threshold voltage, LVT. Fig. 7c shows the configuration used for the embodiment shown in Figs. 1 and 2, where a P-doped secondary well 170 embedded in an N-doped primary well 160 is used as the back gate for both the PMOS and NMOS transistors. Fig. 7d shows an embodiment where an N-doped primary well 160 is used as the back gate for both the PMOS and NMOS transistors and no secondary well is provided. It is noted that for embodiments with N-doped substrates all previously shown well configurations are possible if the primary wells are changed to P-wells and the secondary wells to N-wells. It is further noted, that a primary well may have multiple secondary wells embedded in it.

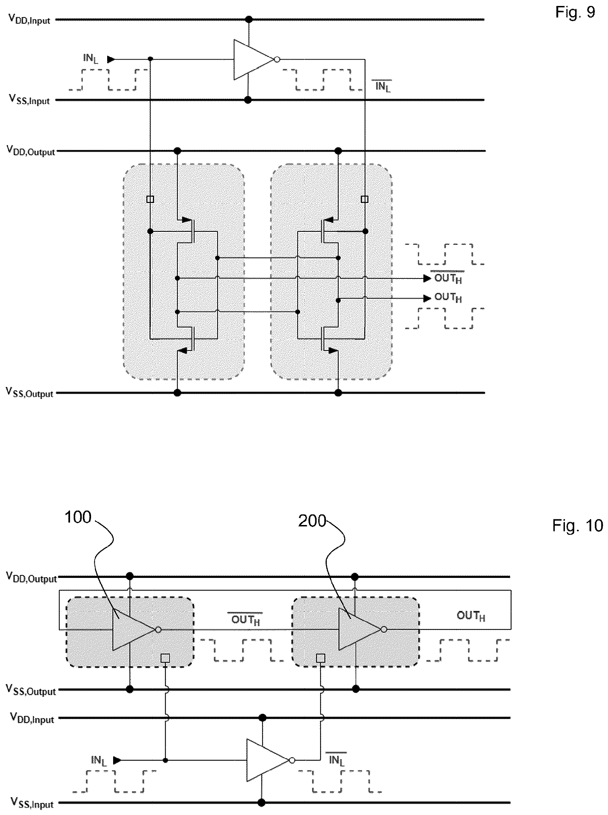

Fig. 8 shows an embodiment using the well configuration of Fig. 7D. Other than the well configuration this embodiment is similar to the ones shown previously. Fig. 9 shows and embodiment similar to that shown in Fig. 8 but differing in that the input circuit 3 has a higher voltage than the first output voltage supply V_{DD,Output} and second output voltage supply V_{SS,Output}, i.e., V_{DD,Output} < V_{SS,Input}. In general, an input circuit with higher voltage may be used for all embodiments including the ones previously described.

Fig. 10 shows an embodiment of the level shifter circuit 1, wherein the first logic gate 100 and the second logic gate 200 are both inverters, e.g., as the embodiment shown in Fig. 8. As previously described, the first output terminal 150 is coupled to the second secondary input terminal 230, which is indicated by the line going from the output of the inverter symbol representing the inverter that is the first logic gate 100 to the input of the inverter symbol representing the inverter that is the second logic gate 200. Likewise, second output terminal 250 is coupled to the first secondary input terminal 130, which is indicated by the line going from the output of the inverter symbol representing the inverter that is the second logic gate 200 to the input of the inverter symbol representing the inverter that is the first logic gate 100.

The latch output terminal 300 is coupled to the output of the inverter that is the second logic gate 200, while the second latch output terminal 400 is coupled to the output of the inverter that is the first logic gate 200.

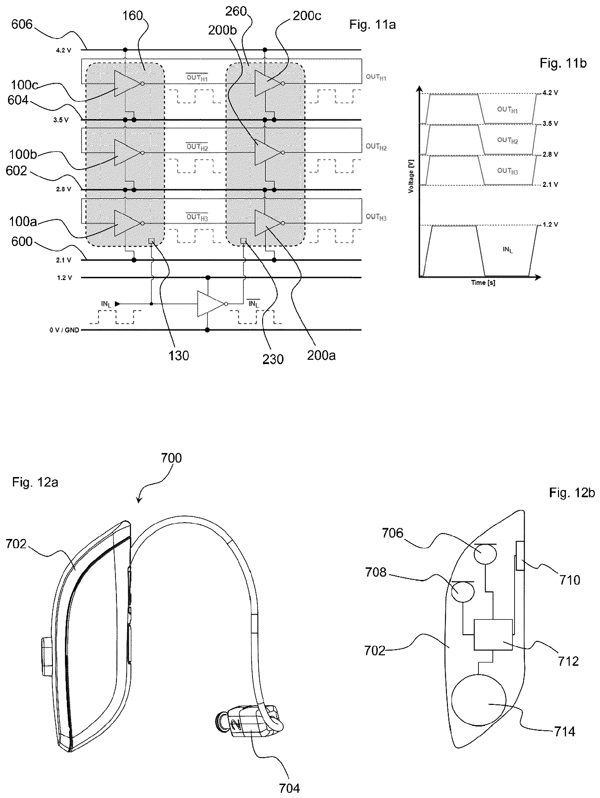

Fig. 11a shows a multi-level shifter circuit according to the second aspect of the invention. The multi-level shifter circuit comprises multiple level shifter circuits, e.g., three level shifter circuits as shown, configured for shifting to different voltage domains 600, 602, 604, 606. Each level shifter circuit is similar to the one shown in Fig. 10. Thus, each level shifter circuit comprises a first logic gate 100a, 100b, 100c and a second logic gate 200a, 200b, 200c, wherein the respective first logic gate 100a, 100b, 100c of each level shifter is cross-coupled to the respective second logic gate 200a, 200b, 200c of that level shifter as described for above.

In the shown embodiment, all of the first logic gates 100a, 100b, 100c have been arranged on top of the same first primary well 160 coupled to a first main input terminal 130 shared by the level shifter circuits. Thereby, the first primary well 160 provides the back gates for the first transistors of the level shifter circuits. Similarly, all of the second logic gates 200a, 200b, 200c have been arranged on top of the same second primary well 260 coupled to a second main input terminal 230 shared by the level shifter circuits. Thereby, the second primary well 160 provides the back gates for the second transistors of the level shifter circuits. By sharing wells amongst logic gates, the implementation area can be reduced. It is noted, that the well configurations described above could also be used for one, more, or all of the first logic gates 100a, 100b, 100c, and/or for one, more, or all of the second logic gates 200a, 200b, 200c.

In the shown embodiment, each level shifter circuit shares its voltage supplies with its neighboring level shifter circuit, i.e., it shares its first output voltage supply V_{DD,Output} with the level shifter circuit immediately above it, whereby the first output voltage supply V_{DD,Output} also becomes the second output voltage supply V_{SS,Output} for the level shifter circuit above it, and it shares its second output voltage supply V_{SS,Output} with the level shifter circuit immediately below it, whereby the second output voltage supply V_{SS,Output} also becomes the first output voltage supply V_{DD,Output} for the level shifter circuit below it. By sharing voltage supplies, the multi-level shifter circuit becomes more efficient as it reduces number of voltages supplies needed in the system.

In the shown embodiment, the voltage supplies have been provided with voltage values, which are merely exemplary for illustration. In the example, the second input voltage supply V_{SS,Output} is 0V or ground, GND, and the first input voltage supply V_{DD,Output} is 1.2V. The lowest voltage level shifter circuit has a second voltage supply 600 providing 2.1V and a first voltage supply 602 providing 2.8V. The middle voltage level shifter circuit has a second voltage supply 602 providing 2.8V and a first voltage supply 604 providing 3.5V. The high voltage level shifter circuit has a second voltage supply 604 providing 3.5V and a first voltage supply 606 providing 4.2V. Thus, it is possible to perform a voltage shift from 0V to any of the second input voltage supplies, i.e. 2.1V, 2.8V, and 3.5V with the exemplary values, and a voltage shift from 1.2V to any of the first input voltage supplies, i.e. 2.8V, 3.5V, and 4.2V with the exemplary values.

Fig. 11b is a graph showing the output of the multi-level shifter circuit of Fig. 11a against the input. As is illustrated with the exemplary values it is possible for the level shifter and multi-level shifter circuit of the invention to perform voltage shifts of more than 3V, even with transistors that are only capable of withstanding voltages of around 1.5V on their front gate before being damaged.

Fig. 12a show a hearing device 700, which in the shown embodiment is a RITE- or MaRie-type hearing aid. The hearing device 700 comprises a BTE component 702 adapted to be worn behind the ear of the user and an ITE component 704 adapted to be worn in the ear of the user.

The hearing device comprises one or more input transducers 706, 708, e.g. one or more microphones and/or one or more bone vibration sensors, configured for capturing sound. The one or more input transducers may be arranged in the BTE component 702 and/or in the ITE component 704. The hearing device 702 comprises at least one output transducer, e.g. a loud speaker, which in the shown embodiment is arranged in the ITE component 704, but which may alternatively be arranged in the BTE component 702.

Fig. 12b show a schematic view of the BTE component 702 of the hearing device 700 shown in Fig. 12a. The hearing device comprises two microphones 706, 708 connected to circuitry 710. The circuitry 712 comprises a processor adapted to process the signals representing the sound captured by the input transducers 706, 708. The BTE component 702 comprises an electrical interface 710 configured for being connected to the ITE component 704. Through the electrical interface 710, the circuitry 712 is connected to the output transducer, whereby processed signals may be sent to the output transducer and converted into an acoustic output.

The hearing device 700 further comprises a power source 714 in the form of a battery, preferably a rechargeable battery. The power source 714 is connected to the circuitry 712 and used to power the hearing device 700. The battery can supply a first voltage, e.g. 4.2V. The circuitry 712 may comprise one or more voltage converters configured for converting the first voltage into one or more further voltages, e.g. 3.5V, 2.8V, 2.1V, and/or 1.2V. The first voltage and the further voltages may then be used for the various voltage supplies.

The use of the terms "first", "second", "third" and "fourth", "primary", "secondary", "tertiary" etc. does not imply any particular order, but are included to identify individual elements. Moreover, the use of the terms "first", "second", "third" and "fourth", "primary", "secondary", "tertiary" etc. does not denote any order or importance, but rather the terms "first", "second", "third" and "fourth", "primary", "secondary", "tertiary" etc. are used to distinguish one element from another. Note that the words "first", "second", "third" and "fourth", "primary", "secondary", "tertiary" etc. are used here and elsewhere for labelling purposes only and are not intended to denote any specific spatial or temporal ordering. Furthermore, the labelling of a first element does not imply the presence of a second element and vice versa.

It is to be noted that the word "comprising" does not necessarily exclude the presence of other elements or steps than those listed. It is to be noted that the words "a" or "an" preceding an element do not exclude the presence of a plurality of such elements.

It should further be noted that any reference signs do not limit the scope of the claims, that the exemplary embodiments may be implemented at least in part by means of both hardware and software, and that several "means", "units" or "devices" may be represented by the same item of hardware.

Although features have been shown and described, it will be understood that they are not intended to limit the claimed invention, and it will be made obvious to those skilled in the art that various changes and modifications may be made without departing from the spirit and scope of the claimed invention. The specification and drawings are, accordingly to be regarded in an illustrative rather than restrictive sense. The claimed invention is intended to cover all alternatives, modifications, and equivalents.

### LIST OF REFERENCES

- 1: level shifter circuit
- 2: latch circuit
- 3: input circuit
- 32: input inverter
- 100: first logic gate
- 100a: first logic gate
- 100b: first logic gate
- 100c: first logic gate
- 110: first transistor
- 112: back gate of first transistor
- 114: front gate of first transistor
- 116: gate oxide of first transistor
- 118: BOX layer of first transistor
- 119: channel of first transistor
- 120: first transistor
- 122: back gate of first transistor
- 124: front gate of first transistor
- 126: gate oxide of first transistor
- 128: BOX layer of first transistor
- 129: channel of first transistor
- 130: first main input terminal
- 132: first secondary well contact
- 134: first primary well contact
- 140: first secondary input terminal
- 150: first output terminal
- 160: first primary well
- 170: first secondary well
- 180: high voltage terminal
- 190: low voltage terminal
- 200: second logic gate
- 200a: second logic gate
- 200b: second logic gate
- 200c: second logic gate
- 210: second transistor
- 212: back gate of second transistor
- 214: front gate of second transistor
- 216: gate oxide of second transistor
- 218: BOX layer of second transistor
- 219: channel of second transistor
- 220: second transistor
- 222: back gate of second transistor
- 224: front gate of second transistor
- 226: gate oxide of second transistor
- 228: BOX layer of second transistor
- 229: channel of second transistor
- 230: second main input terminal
- 232: second secondary well contact
- 234: second primary well contact
- 240: second secondary input terminal
- 250: second output terminal
- 260: second primary well
- 270: second secondary well
- 280: high voltage terminal
- 290: low voltage terminal
- 300: latch output terminal
- 400: second latch output terminal
- 500: substrate
- 600: voltage supply
- 602: voltage supply
- 604: voltage supply
- 606: voltage supply
- 700: hearing device
- 702: BTE component
- 704: ITE component
- 706: input transducer
- 708: input transducer
- 710: electrical interface
- 712: circuitry
- V_{DD,Output}: first output voltage supply
- V_{SS,Output}: second output voltage supply
- V_{DD,Input}: first input voltage supply
- V_{SS,Intput}: second input voltage supply
- IN_{L}: Input signal
- I̅N̅_̅{̅L̅}̅: Inverted input signal
- OUT_{H}: Output signal
- O̅U̅T̅_̅{̅H̅}̅: Inverted output signal

## Claims

1. A level shifter circuit (1) comprising:
a first output voltage supply (V_{DD,Output});
a second output voltage supply (V_{SS,Output}), the second output voltage supply (V_{SS,Output}) having a lower voltage than the first output voltage supply (V_{DD,Output}); and
a latch circuit (2) comprising
a first logic gate (100) having
at least two first transistors (110, 120), each of the first transistors (110, 120) being multi-gate transistors having a front gate (114, 124) and a back gate (112, 122),
a first main input terminal (130) coupled to the back gates (112, 122) of the first transistors (110, 120),
a first secondary input terminal (140) coupled to the front gates (114, 124) of the first transistors (110, 120), and
a first output terminal (150),
a second logic gate (200) having
at least two second transistors (210, 220), each of the second transistors (210, 220) being multi-gate transistors having a front gate (214, 224) and a back gate (212, 222),
a second main input terminal (230) coupled to the back gates (212, 222) of the second transistors (210, 220),
a second secondary input terminal (240) coupled to the front gates (214, 224) of the second transistors (210, 220), and
a second output terminal (250),
a latch output terminal (300)
wherein the first secondary input terminal (140) is coupled to the second output terminal (250),
wherein the second secondary input terminal (240) is coupled to the first output terminal (150),
wherein the latch circuit (2) has a first state in which the latch output terminal (300) is coupled to the first output voltage supply (V_{DD,Output}),
wherein the latch circuit (2) has a second state in which the latch output terminal (300) is coupled to the second output voltage supply (V_{SS,Output}), and
wherein the latch circuit (2) is configured for being brought into the first state or the second state based on inputs to the first main input terminal (130) and the second main input terminal (230).

2. The level shifter circuit of claim 1, wherein the level shifter circuit further comprises an input circuit, the input circuit comprising:
a first input voltage supply, and
a second input voltage supply, the second input voltage supply having a lower voltage than the first input voltage supply,
wherein the first input voltage supply and the second input voltage supply are coupled to the first main input terminal and the second main input terminal, optionally one of the first main input terminal and the second main input terminal being coupled to the first input voltage supply and the second input voltage supply through an inverter.

3. The level shifter circuit of claim 2, wherein both the first input voltage supply and the second input voltage supply have a lower voltage than the second output voltage supply, or
wherein both the first input voltage supply and the second input voltage supply have a higher voltage than the first output voltage supply.

4. The level shifter circuit of any of the previous claims, wherein the at least two first transistors comprise a first NMOS transistor and a first PMOS transistor, and/or
wherein the at least two second transistors comprise a second NMOS transistor and a second PMOS transistor.

5. The level shifter circuit of claim 4, wherein the first NMOS transistor and the first PMOS transistor are asymmetric, and/or
wherein the second NMOS transistor and the second PMOS transistor are asymmetric.

6. The level shifter circuit of any of the previous claims, wherein the first logic gate comprises one or more first primary well(s), and/or
wherein the second logic gate comprises one or more second primary well(s).

7. The level shifter circuit of claim 6, wherein the first logic gate comprises one or more first secondary well(s), each of the one or more first secondary well(s) being embedded in a first primary well, and/or
wherein the second logic gate comprises one or more second secondary well, each of the one or more second secondary well(s) being embedded in a second primary well.

8. The level shifter circuit of any of the previous claims, wherein the first logic gate is an inverter circuit, and the second logic gate is an inverter circuit.

9. The level shifter circuit of any of the previous claims, wherein the latch circuit is configured for switching between the first and second states in less than 1 ns.

10. The level shifter circuit of any of the previous claims, wherein the first transistors and/or second transistors are one or more of the following type:
Partially Depleted Silicon on Oxide, PD-SOI, field effect transistor, FET,
Fully Depleted Silicon on Oxide, FD-SOI, FET,
finFET, and
flexFET.

11. The level shifter circuit of any of the previous claims, wherein the first logic gate and the second logic gate are symmetric with each other.

12. A multi-level shifter circuit comprising two or more level shifter circuits according to any of the previous claims,
wherein the first main input terminals of the two or more level shifter circuits are connected,
wherein the second main input terminals of the two or more level shifter circuits are connected, and
wherein the first output voltage supply of each level shifter is provided with different voltages and/or the second output voltage supply of each level shifter circuit is provided with different voltages.

13. The multi-level shifter circuit of claim 12, wherein the second output voltage supply of a first level shifter circuit of the two or more level shifter circuits provides the first output voltage supply of a second level shifter circuit of the two or more level shifters.

14. The multi-level shifter circuit of claims 12 or 13, wherein two or more level shifter circuits shares a first primary well, and/or
wherein the two or more level shifter circuits shares a second primary well.

15. A hearing device configured to be worn at the ear of a user, wherein the hearing device comprises:
one or more input transducers;
an output transducer;
a battery; and
circuitry with two or more voltage domains, the circuitry comprising a level shifter circuit according to any of claims 1-11 or a multi-level shifter circuit according to any of claims 12-14.
